# EUROPÄISCHE PATENTANMELDUNG

(11) **EP 2 086 060 A2**
(43) Veröffentlichungstag der Anmeldung: **05.08.2009**
(21) Anmeldenummer: 09151550.2
(22) Anmeldetag: 28.01.2009
(51) Int. Cl.: H01R 12/34, F15B 13/08

(54) **Einrichtung zur elektrischen Kontaktierung der Drahtenden einer elektrischen Spule**

(30) Priorität: 30.01.2008 DE 102008006773
(71) Anmelder: Robert Bosch GmbH, 70442 Stuttgart (DE)
(72) Erfinder: Koch, Jens, 30451 Hannover (DE); Möller, Rudolf, 30989 Gehrden (DE)
(74) Vertreter: Kietzmann, Lutz

(57) **Zusammenfassung**

Einrichtung zur elektrischen Kontaktierung der Drahtenden einer elektrischen Spule (1) mit einer Leiterplatte (2) zur Bestromung der elektrischen Spule (1), wobei zur lötfreien Kontaktierung die Drahtenden der elektrischen Spule (1) mit je einem Einpresskontakt (6a,6b) versehen ist, der in korrespondierende Durchgangsbohrungen (7a,7b) seitens der Leiterplatte (2) zum Eingriff kommt, deren Innenwandfläche mit einer metallischen Leiterbahn überzogen ist.

## Beschreibung

Die vorliegende Erfindung betrifft eine Einrichtung zur elektrischen Kontaktierung der Drahtenden einer elektrischen Spule mit einer Leiterplatte zur Bestromung der elektrischen Spule.

Das Einsatzgebiet der vorliegenden Erfindung erstreckt sich auf fluidtechnische Anlagen, bei denen elektromagnetische Ventile zur Steuerung der Fluidflüsse zum Einsatz kommen. Neben Mehrwegeventilen mit unterschiedlichsten Ventilfunktionen kommen auch Druckregelventile und andere Arten von Ventilen zum Einsatz. Während Mehrwegeventile in den meisten Fällen mit Ventilschiebem als Schaltglied bestückt sind und per elektropneumatischer Vorsteuerung betätigt werden, sind Regelventile meist nach dem Ventilsitzprinzip konstruiert und weisen einen Proportionalmagneten als elektromagnetischen Antrieb aus. Bei all diesen Ventilen der hier interessierenden Art ist das Problem der elektrischen Verbindung der Drahtenden der Spule an elektrische Anschlussleitungen zu lösen. Diesem Thema widmet sich die vorliegende Erfindung.

Aus dem allgemeinen Stand der Technik ist es bekannt, in einem die elektrische Spule umgebenden Gehäuse einen Steckverbinder zu integrieren, über welchen sich eine elektrische Leitung zur Bestromung der Spule lösbar anbringen lässt. Bei einigen Anwendungsfällen lässt sich wegen knappem Bauraum eine solche Steckerlösung nicht realisieren und die Drahtenden der elektrischen Spule werden direkt bauraumsparend mit einer Leiterplatte verlötet, deren Leiterzüge die elektrische Verbindung zur Spule herstellen. Die Leiterplatte nimmt gewöhnlich hierbei auch eine Trägerfunktion für die elektrische Spule wahr. Nachteilig hierbei ist jedoch der fertigungstechnische Aufwand, der mit dem Anlöten der Spulenenden bei Montage derselben am Mehrwegeventil verbunden ist. Außerdem lässt sich eine defekte elektrische Spule im Reparaturfall nur durch wiederholtes Löten demontieren.

Bei der in DE 197 25 289 A1 offenbarten technischen Lösung wird die vorstehend geschilderte Problematik dadurch gelöst, dass sich die elektrische Spule mit hieran ausgebildeten elektrischen Kontakten lösbar an einer Leiterplatte per Bayonettverschluss montieren lässt. Mit der schenkenden Montagebewegung zur Arretierung des Bayonettverschlusses wird gleichzeitig der elektrische Kontakt mit den Leiterbahnen an der Leiterplatte in Übereinstimmung gebracht, so dass eine zuverlässige elektrische Kontaktierung möglich wird. Zwar entfallen hierdurch umständliche Lötarbeiten im Zuge der Montage, jedoch sind die Kontakte selbst recht aufwendig gestaltet. Denn das elektrische Kontaktierungsprinzip beruht hier auf einer auf die elektrischen Kontakte aufgebrachte Federvorspannung durch die Montagebewegung.

Es ist die Aufgabe der vorliegenden Erfindung, eine Einrichtung zur elektrischen Kontaktierung von Drahtenden einer elektrischen Spule, insbesondere für elektromagnetische Mehrwegeventile, zu schaffen, welche bauraumsparend konstruiert ist und sich durch eine einfache Montage und leichte Demontage der elektrischen Spule im Reparaturfall auszeichnet.

Die Aufgabe wird ausgehend von einer Einrichtung gemäß dem Oberbegriff von Anspruch 1 in Verbindung mit dessen kennzeichnenden Merkmalen gelöst. Die nachfolgenden abhängigen Ansprüche geben vorteilhafte Weiterbildungen der Erfindung wieder.

Die Erfindung schließt die technische Lehre ein, dass zur lötfreien Kontaktierung die Drahtenden der elektrischen Spule mit je einem Einpresskontakt versehen sind, der in korrespondierende Durchgangsbohrungen seitens der Leiterplatte zum Eingriff kommt, deren Innenwandfläche mit einer metallischen Leiterbahn überzogen ist. Dabei werden im Rahmen der vorliegenden Erfindung unter dem Begriff Durchgangsbohrung nicht allein streng geometrisch gesehen zylindrische Durchbrüche verstanden. Es sind vielmehr auch polygonale Querschnitte denkbar.

Der Vorteil der erfindungsgemäßen Lösung liegt insbesondere darin, dass unter Verzicht auf Stecker-Buchsen-Anschlüsse sich eine bauraumsparende Lösung realisieren lässt. Die direkt mit Einpresskontakten versehene elektrische Spule lässt sich denkbar einfach montieren, indem die Einpresskontakte in die vorgesehenen Durchgangsbohrungen eingepresst werden. Mit der elektrischen Verbindung lässt sich im Sinne einer Funktionsintegration gleichzeitig auch eine mechanische Befestigung der elektrischen Spule an der insoweit tragenden Leiterplatte realisieren. Ferner bietet die erfindungsgemäße Lösung die technische Voraussetzung dafür, die elektrische Spule im Reparaturfall leicht auszutauschen. Diese ist durch Herausziehen von der Leiterplatte leicht trennbar und kann gegen eine funktionstüchtige Spule ausgetauscht werden, deren Einpresskontakte wiederum lediglich in die Durchgangsbohrungen einzupressen sind.

Gemäß einer die Erfindung verbessernden Maßnahme ist vorgesehen, dass jeder Einpresskontakt eine mittlere Ausnehmung zur Erzeugung von beidseits hiervon verbleibenden federnden Kontaktflanken aufweist. Die mittlere Ausnehmung ist also im Verhältnis zum restlichen Material des Einpresskontaktes derart gestaltet, dass genügende federnde Kontaktflanken verbleiben, welche in der Lage sind, den Kontakt nach dem Einpressen sicherzustellen. Denn der Einpresskontakt soll vorzugsweise unter Vorspannung in die korrespondierende Durchgangsbohrung eingepresst werden, so dass ein sicherere elektrischer Kontakt gewahrt bleibt und mechanische Wechselbeanspruchungen an der elektrischen Spule, beispielsweise Schwingungen einer Maschine, den elektrischen Kontakt nicht gefährden können.

Im Hinblick auf eine die Fertigungstechnik vereinfachende Maßnahme wird vorgeschlagen, dass an einem aus Kunststoff bestehenden Spulenkörper der elektrischen Spule ein Paar von mit den Drahtenden verbundenen Einpresskontakten eingegossen werden. Somit kann mit dem Spritzgießen des Spulenkörpers auch gleich eine mechanische Befestigung der Einpresskontakte erfolgen. Alternativ hierzu ist es auch denkbar, Ausnehmungen zum Einstecken der Einpresskontakte in den aus Kunststoff bestehenden Spulenkörper vorzusehen. Lässt man in diese Ausnehmungen die blanken Drahtenden hineinragen, so lassen diese sich durch Klemmen in Folge Einpressen der Einpresskontakte in den Spulenkörper elektrisch kontaktieren. Gemäß einer weiteren, die Erfindung verbessernden Maßnahme wird vorgeschlagen, dass jeder Einpresskontakt im Querschnitt ein U-Profil aufweist. Die Schenkelbereich des so profilierten Einpresskontakts lassen sich dann flächig mit der Innenwandung der Durchgangsbohrung zur Anlage bringen, was einen großflächigen elektrischen Kontakt ermöglicht.

Eine die erfindungsgemäße Lösung im Hinblick auf eine möglichst leichte Einpressbarkeit der Einpresskontakte verbessernde Lösung sieht vor, die Einpresskontakte am distalen Ende mit Einlaufschrägen zum Hineinführen in die korrespondierede Durchgangsbohrung zu versehen. Diese Einlaufschrägen bilden dabei einen spitzen Winkel mit der Längsachse der im Wesentlichen zylindrischen Durchgangsbohrung mit metallisierter Innenwandfläche.

Gemäß einer bevorzugten Ausführungsform der Erfindung weist die Leiterplatte vorzugsweise in Reihe mehrere Paare von Durchgangsbohrungen zur Aufnahme entsprechend mehrerer elektrischer Spulen auf, wobei von den Durchgangsbohrungen jeweils elektrische Leiterzüge ausgehen, die in einem Mehrfachsteckanschluss münden. Diese spezielle Ausführungsform eignet sich insbesondere zur Reihenanordnung mehrerer elektrischer Spulen zum Aufbau einer pneumatischen Ventileinheit, bei welcher bekanntermaßen mehrere elektromagnetische Mehrwegeventile aneinandergereiht sind, um blockartig zusammengefasst ein pneumatisches System anzusteuern. Durch diese spezielle Lösung für eine elektrische Einrichtung zur Kontaktierung der einzelnen Spulen lässt sich über einen zentralen Mehrfachsteckanschluss die Verbindung mit einer übergeordneten Steuereinheit herstellen.

Weitere, die Erfindung verbessernden Maßnahmen werden nachstehend gemeinsam mit der Beschreibung eines bevorzugten Ausführungsbeispiels der Erfindung anhand der Figuren näher dargestellt. Es zeigt:
- Fig.1: eine perspektivische Ansicht einer Einrichtung zur elektrischen Kontaktierung elektrischer Spulen mit einer Leiterplatte,
- Fig.2: eine Seitenansicht der elektrischen Spulen im montierten Zustand an der Leiterplatte, und
- Fig.3: eine Detailansicht von Fig.2 im Bereich eines Einpresskontakts.

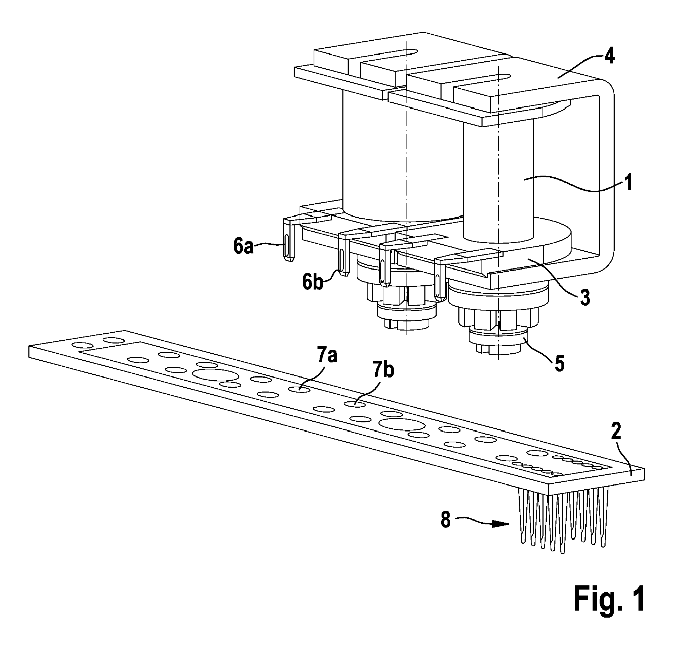

Gemäß Fig.1 umfasst eine Einrichtung zur Kontaktierung der Drahtenden einer elektrischen Spule 1 eine mit dieser zu kontaktierende und die elektrische Spule 1 tragende Leiterplatte 2. Die Wicklungen der elektrischen Spule 1 sind um einen Spulenkörper 3 gewunden, welcher aus Kunststoff besteht. Um die elektrische Spule 1 herum erstreckt sich ein U-förmiges Joch 4 zur Leitung des äußeren Magnetkreises. Die elektrische Spule 1 dient der Betätigung eines Stößels 5 für ein - nicht weiter dargestelltes - Sitzventil.

Zur lötfreien Kontaktierung der Drahtenden der elektrischen Spule 1 sind die Drahtenden jeweils mit einem Einpresskontakt 6a, 6b versehen und elektrisch verbunden. Jeder Einpresskontakt 6a und 6b ist einer Durchgangsbohrung 7a bzw. 7b seitens der Leiterplatte 2 zugeordnet. Durch Einpressen der Einpresskontakte 6a, 6b in die korrespondierenden Durchgangsbohrungen 7a bzw. 7b erfolgt sowohl die mechanische Befestigung der Spule 1 an der Leiterplatte 2 als auch deren elektrische Verbindung. Denn die Durchgangsbohrungen 7a, 7b sind innenwandig mit metallischen Leiterbahnen überzogen, die an je einem Pin eines Mehrfachsteckanschlusses 8 der Leiterplatte 2 enden. Hierüber erfolgt die parallele Verdrahtung jeder einzelnen elektrischen Spule 1.

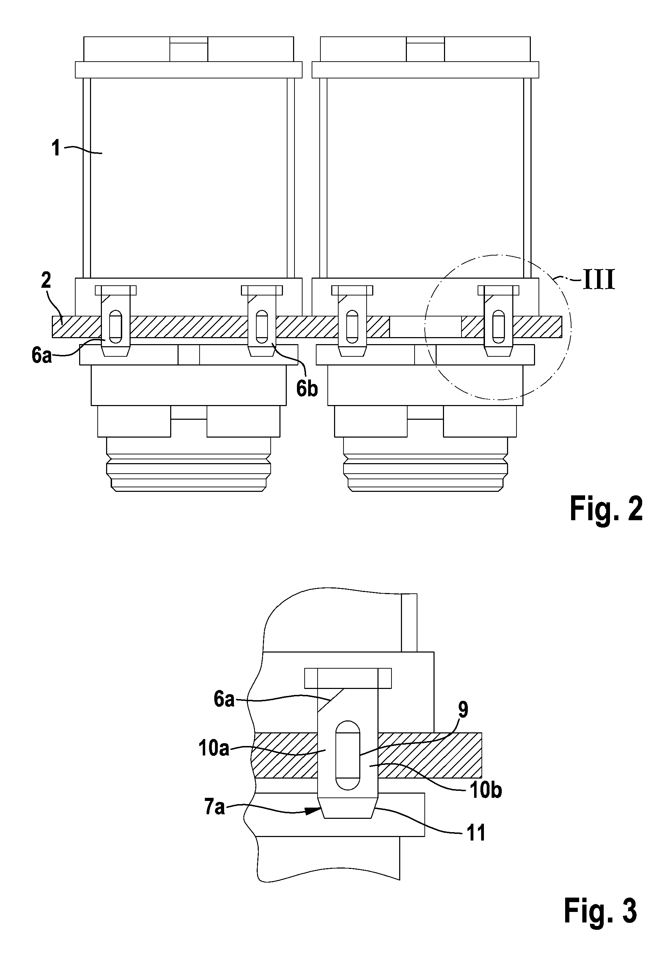

Gemäß Fig.2 sind die hier exemplarisch an der elektrischen Spule 1 ausgebildeten beiden Einpresskontakte 6a und 6b in die korrespondierenden Durchgangsbohrungen der Leiterplatte 2 eingepresst und bilden somit eine mechanische und elektrische Verbindung. Ein sicherer Halt wird dadurch gewährleistet, in dem die Einpresskontakte 6a und 6b (exemplarisch) unter Vorspannung stehen.

Gemäß Fig.3 wird diese Vorspannung erreicht, indem jeder Einpresskontakt 6a (exemplarisch) eine mittige Ausnehmung 9 zur Erzeugung von beidseits hiervon verbleibenden federnden Kontaktfahnen 10a und 10b aufweist. Ferner ist der Einpresskontakt 6a an seinem distalen Ende mit Einlaufschrägen 11 versehen. Die Einlaufschrägen 11 dienen dem erleichterten Hineinführen in die korrespondierende Durchgangsbohrung 7a.

### Bezugszeichenliste

- **1**: elektrische Spule
- **2**: Leiterplatte
- **3**: Spulenkörper
- **4**: Joch
- **5**: Stößel
- **6**: Einpresskontakt
- **7**: Durchgangsbohrung
- **8**: Mehrfachsteckanschluss
- **9**: Ausnehmung
- **10**: Kontaktflanke
- **11**: Einlaufschräge

## Patentansprüche

1. Einrichtung zur elektrischen Kontaktierung der Drahtenden einer elektrischen Spule
(1) mit einer Leiterplatte (2) zur Bestromung der elektrischen Spule (1),
**dadurch gekennzeichnet, dass** zur lötfreien Kontaktierung die Drahtenden der elektrischen Spule (1) mit je einem Einpresskontakt (6a,6b) versehen ist, der in korrespondierende Durchgangsbohrungen (7a,7b) seitens der Leiterplatte (2) zum Eingriff kommt, deren Innenwandfläche mit einer metallischen Leiterbahn überzogen ist.

2. Einrichtung nach Anspruch 1,
**dadurch gekennzeichnet, dass** der Einpresskontakt (6a,6b) eine mittige Ausnehmung (9) zur Erzeugung von beidseits hiervon verbleibenden federnden Kontaktflanken (10a,10b) aufweist.

3. Einrichtung nach Anspruch 2,
**dadurch gekennzeichnet, dass** der Einpresskontakt (6a,6b) unter Vorspannung in die korrespondierende Durchgangsbohrung (7a,7b) einpressbar ist.

4. Einrichtung nach Anspruch 1,
**dadurch gekennzeichnet, dass** ein Paar von mit den Drahtenden verbundenen Einpresskontakten (6a,6b) in einen stirnseitigen Abschnitt des aus Kunststoff bestehenden Spulenkörpers (3) der elektrischen Spule (1) eingegossen ist.

5. Einrichtung nach Anspruch 1,
**dadurch gekennzeichnet, dass** der Einpresskontakt (6a,6b) im Querschnitt ein U-Profil aufweist, um mit an der Innenwandfläche der Durchgangsbohrungen (7a,7b) zur Anlage kommenden Schenkelbereichen einen großflächigen elektrischen Kontakt sicherzustellen.

6. Einrichtung nach Anspruch 1,
**dadurch gekennzeichnet, dass** der Einpresskontakt (6a,6b) am distalen Ende Einlaufschrägen (11) zum Hineinführen in die Durchgangsbohrung (7a,7b) aufweist.

7. Einrichtung nach einem der vorstehenden Ansprüche,
**dadurch gekennzeichnet, dass** die Leiterplatte (2) mehrere Paare von Durchgangsbohrungen (7a,7b) zur Aufnahme entsprechend mehrerer elektrischer Spulen (1) aufweist, wobei von den Durchgangsbohrungen (7a,7b) jeweils elektrische Leiterzüge ausgehen, die in einen Mehrfachsteckanschluss (8) münden.

8. Ventileinheit mit mehreren aneinandergereihten elektromagnetischen Mehrwegeventilen, welche über elektrische Spulen (1) angesteuert werden, die mit einer elektrischen Einrichtung nach einem der vorstehenden Ansprüche angeschlossen sind.
